# EUROPÄISCHE PATENTSCHRIFT

(11) **EP 3 132 254 B1**
(45) Veröffentlichungstag und Bekanntmachung des Hinweises auf die Patenterteilung: **02.06.2021**
(21) Anmeldenummer: 15712910.7
(22) Anmeldetag: 30.03.2015
(51) Int. Cl.: G01N 27/333, G01N 27/36

(54) **VERFAHREN ZUR HERSTELLUNG EINER PH-HALBZELLE UND EINE PH-HALBZELLE**
METHOD FOR PRODUCING A PH HALF-CELL, AND A PH HALF-CELL
PROCÉDÉ DE PRODUCTION D'UNE DEMI-CELLULE À PH ET DEMI-CELLULE À PH

(30) Priorität: 17.04.2014 DE 102014105575
(43) Veröffentlichungstag der Anmeldung: 22.02.2017
(73) Patentinhaber: Innovative Sensor Technology IST AG, 9642 Ebnat-Kappel (CH)
(72) Erfinder: KROGMANN, Florian, CH-8280 Kreuzlingen (CH)
(74) Vertreter: Andres, Angelika Maria
(86) Internationale Anmeldenummer: PCT/EP2015/056829
(87) Internationale Veröffentlichungsnummer: WO 2015/158533

(56) Entgegenhaltungen:
- EP-A2- 0 269 031
- DE-A1- 3 134 760
- DE-A1- 19 714 474
- DE-A1-102007 016 197
- GB-A- 2 015 742

## Beschreibung

Die Erfindung bezieht sich auf Verfahren zur Herstellung einer pH-Halbzelle mittels derer ein pH-Wert eines Mediums bestimmbar ist, sowie eine solche pH-Halbzelle.

Die qualitative Bestimmung des pH-Wertes eines Mediums ist in vielen Prozessen ein unerlässlicher Prozessparameter. Aus dem Stand der Technik sind daher diverse Techniken bekannt den pH-Wert zu ermitteln.

Zur Messung von lonenaktivitäten werden typischerweise ionenselektive Elektroden verwendet. Die gängigste Variante dürfte dabei eine Glaselektrode sein. Unter Glaselektroden werden üblicherweise Festkörpermembranen aus silikatischen Gläsern verstanden, die meist aus Oxiden oder Carbonaten erschmolzen werden und anschließend glasbläserisch in die endgültige Fassung gebracht werden. Wird eine derartige Glaselektrode in eine wässrige Lösung getaucht, bildet sich am pH-sensitiven Membranglas eine Quellschicht aus. Dies geschieht auch an der Glasmembraninnenseite, die mit einer definierten Pufferlösung, bspw. einer Kaliumchloridpuffer (KCL) in Kontakt steht. Damit der pH-Wert gemessen werden kann, wird neben der Glaselektrode auch eine Bezugselektrode benötigt.

Derartige Glaselektroden sind im Allgemeinen sehr groß in ihrer Ausführung. Aus diesem Grund ist die mögliche Integrationsdichte, d.h. die Anzahl an weiteren Sensoren pro Flächeneinheit, sehr beschränkt und eignet sich somit auch nicht für den Einsatz in Prozessen mit kleinsten Mengen des Analyts, bspw. im nL-, µL- oder im mL-Bereich. Weiterhin weisen derartige Glaselektroden das Problem auf, dass sie aufgrund ihrer Zerbrechlichkeit und der Möglichkeit einer Verunreinigung in dem Fall, dass das Glas bricht, in manchen Applikationen nicht eingesetzt werden dürfen.

Aus dem Stand der Technik sind auch ionenselektive Feldeffekttransistoren (ISFET) bekannt, die den pH-Wert mittels einer pH-sensitiven Schicht (z.B. Ta₂O₅, SiN, Al₂O₃), die auf dem Gate aufgebracht ist, messen. Bei derartigen ISFETs wird das zu messende Potential in ein Stromsignal gewandelt.

ISFETs haben den Nachteil, dass sie sehr empfindlich auf Strahlung reagieren. Gerade beim Einsatz in biologischen Prozessen ist aber eine Sterilisation unabdingbar, wobei dort oft auf Gamma Sterilisation zurückgegriffen wird. Dies ist mit ISFET Sensoren nicht machbar. Weiterhin werden ISFETS meist in CMOS Prozessen hergestellt, da die Elektronik zur Auswertung direkt auf dem Chip aufgebracht wird. Dies limitiert eine mögliche Integration von anderen Messgrößen, da es starke Inkompatibilitäten der Prozesse untereinander gibt. So sind manche Metalle, bei hohen Temperaturen gar nicht oder nur sehr beschränkt nutztbar.

Ebenfalls aus dem Stand der Technik sind Dickschichtelektroden auf Basis von RuO₂ oder ähnlichen Metalloxiden mit pH Sensitivität bekannt, die typischerweise mittels eines metallischen Festableiters arbeiten.

Nachteilig bei Dickschichtelektroden ist im Allgemeinen die starke Abhängigkeit des Messsignals vom Redoxpotential des Analyts. Aus diesem Grund sind derartige Dickschichtelektroden nur in Einsatzgebieten von Interesse, in denen das Redoxpotential des Analyts im Wesentlichen konstant bleibt.

Ebenso sind Dickschichtsensoren aus dem Stand der Technik bekannt. Diese arbeiten auf Basis eines pH-sensitiven Glases, das mittels einer Festableitung(z.B. aus Platin) gemessen wird. Dabei kommen als Substrat für die Dickschichtsensoren sogenannte Hochtemperatur-Mehrlagenkeramiken (englisch: Hight Temperature Cofired Ceramics, kurz "HTCC") zum Einsatz.

Die Nutzung von HTCC Prozessen limitiert die möglichen Materialien und Strukturgenauigkeiten, aufgrund der Schrumpfung während des HTCC Prozesses, sowie der Kompatibilitäten der Materialien untereinander. Aufgrund der Reproduzierbarkeit der Schrumpfung während dem Einbrennen, sind diese Sensoren relativ groß gehalten. Weiterhin müssen alle beteiligten Materialien sehr hohe Temperaturen aushalten.

Neben einer Hochtemperatur-Mehrlagenkeramik als Substrat kommen auch Stahlsubstrate zum Einsatz. Die Nutzung von Stahlsubstraten bringt den Nachteil mit sich, dass diese beim Einbrennen von Dickschichtpasten entweder oxidieren, was Verschmutzungen der sensitiven Schichten hervorrufen kann oder aber, dass das Einbrennen in sauerstoff-armer Atmosphäre geschehen muss, was wiederum mit vielen Materialien nicht durchführbar bzw. kompatibel ist.

Ferner sind aus dem Stand der Technik Farbstoffsensoren bekannt, welche ihre Farbe oder Fluoreszenz-Zeiten je nach pH Wert verändert. Diese werden durch ein optisches System ausgelesen.

Nachteilig ist hierbei, dass die Farbstoffsensoren durch sehr aufwendig optische Systeme ausgelesen werden müssen. Daneben weisen diese oftmals eine geringe Langzeitstabilität auf. Weiterhin erfordern sie oftmals eine Nachkalibration nach Sterilisierungsprozessen. Da die Güte der Anbindung des optischen Systems mit in die Messgenauigkeit spielt, muss bei Disposable Anwendungen (also Einwegprodukten) oftmals zumindest eine 1-Punkt-Kalibrierung durchgeführt werden. Ein weiterer Nachteil, den derartige Farbstoffsensoren aufweisen, ist die relativ geringe Langzeitstabilität. Dies macht im Endeffekt den Sensor in seiner Benutzung teuer. Außerdem degradieren Farbstoffsensoren sehr schnell, bspw. durch Bleichung.

Eine artverwandte pH-Halbzelle wird in EP0269031 offenbart.

Der Erfindung liegt daher die Aufgabe zugrunde, die zuvor beschriebenen Probleme zu überwinden.

Die Aufgabe wird durch ein Verfahren zur Herstellung einer pH-Halbzelle entsprechend dem Anspruch 1, eine pH-Halbzelle entsprechend dem Anspruch 8, sowie ein Sensorsystem zur Bestimmung eines pH-Wertes entsprechend dem Anspruch 14 gelöst.

Erfindungsgemäß wird also eine pH-Halbzelle vorgeschlagen, die durch die Kombination von Dünnschichtprozessen und Dickschichtprozessen hergestellt wird, wobei die pH-Halbzelle rein passiv, d.h. ohne integrierte Elektronik, aufgebaut wird.

Mittels Dünnschichtprozessen lassen sich Strukturen bzw. Schichtendicken im Bereich von 50nm bis 1 Mikrometer herstellen. Gängige Verfahren sind dabei Sputtern, Aufdampfen oder die chemische Gasphasenabscheidung (engl. chemical vapour depostion, kurz: CVD).

Im Vergleich dazu lassen sich mittels Dickschichtprozessen sich Strukturen bzw. Schichtendickten ab ca. 2 Mikrometer aufwärts herstellen. Gängige Verfahren sind Siebdruck, Schablonendruck oder Tauchverfahren, evtl. auch Ink-Jet Verfahren. Durch die Kombination können die Vorteile der Dünnschichttechnologie (geringe Strukturgrössen, viele verschiedene kostengünstig aufbringbare Schichtsysteme) und der Dickschichttechnologie (gute Passivierungsschichten, Robustheit gegenüber Prozessfluktuationen, grosse Materialvielfalt im Bereich von Mischmaterialien (Gläser, Glas/Metallmischschichten)) kombiniert werden. Ferner ist es, durch die Kombination der beiden Verfahren zur Herstellung einer pH-Halbzelle neben dem reinen messen des pH-Wertes des Mediums auch möglich, weitere physikalische und/oder chemische Größen zu messen, wie bspw. die Temperatur, das Redox-Potential, lonenkonzentration (z.B. Cl), gelöst-Sauerstoff, Strömungsgeschwindigkeit oder auch der gesamte organische Kohlenstoff. Hierzu müsste lediglich eine weitere Struktur, bspw. aus Platin, auf dem Substrat der pH-Halbzelle aufgebracht sein.

Im Folgenden wird für unter einem gemischt-leitenden Glas, ein Glas verstanden, das sowohl Elektronen als auch Ionen leitend ist. Unter einem pH-sensitiven Glas ist ein Glas zu verstehen, das mit Feuchtigkeit oder Wasser reagiert und an der Oberfläche eine hauchdünne, nicht sichtbare wasserhaltige Quellschicht bildet. Diese Gel- oder Quellschicht ist pH-selektiv und tritt mit den Wasserstoff-Ionen der Messlösung in Wechselwirkung. Die Quellschicht kann als selektive Barriere betrachtet werden, wobei die Wasserstoff-Ionen durch könne, alle anderen Ionen jedoch nur in einem erheblich geringeren Maße.

Eine vorteilhafte Ausführungsform sieht vor, dass die zweite Struktur mittels eines Dünnschichtverfahrens aufgebracht wird, wobei als Dünnschichtverfahren insbesondere ein Sputter-, ein Aufdampf- oder ein chemisches Gasphasenabscheidungsverfahren verwendet wird.

Eine weitere vorteilhafte Ausführungsform sieht vor, dass die strukturierte Passivierungsglasschicht, das gemischt-leitende Glas und das pH-sensitive Glas mittels eines Dickschichtverfahrens aufgebracht werden, wobei als Dickschichtverfahren insbesondere ein Siebdruck-, ein Schablonendruck-, ein Tauch- oder ein Inkjetverfahren verwendet wird.

Eine weitere vorteilhafte Ausführungsform sieht vor, dass das Material aus dem die erste Struktur ausgebildet wird, Platin oder dotiertes Platin aufweist.

Eine weitere vorteilhafte Ausführungsform sieht vor, dass das Material aus dem die zweite Struktur gebildet wird, Platin, dotiertes Platin oder Gold aufweist. Insbesondere sieht die Ausführungsform vor, dass in dem Fall, dass die zweite Struktur aus Platin oder dotiertem Platin ausgebildet wird, eine Goldschicht auf die aus Platin oder dotiertem Platin ausgebildete zweite Struktur aufgebracht wird, so dass die Goldschicht die zweite aus Platin oder dotiertem Platin ausgebildete Struktur im Wesentlichen bedeckt und das gemischt-leitende Glas die Goldschicht im Wesentlichen bedeckt und das pH-sensitive Glas das gemischt-leitende Glas im Wesentlichen bedeckt.

Die Erfindung sieht vor, dass das Verfahren einen Trimmschritt vorsieht, bei dem nach dem Aufbringen der ersten Struktur diese auf einen vorgegebenen Widerstandswert bei Referenzbedingungen getrimmt wird, wobei diese Referenzbedingungen der DIN-Norm 60751 aus dem Jahr 2008 beschrieben bzw. vorgegeben sind.

Eine weitere vorteilhafte Ausführungsform sieht vor, dass die erste Struktur so ausgebildet wird, dass sie zumindest zwei Anschlusskontakte, über die das Widerstandselement an die Auswertelektronik elektrisch angeschlossen wird, aufweist und die zweite Struktur so ausgebildet wird, dass sie zumindest einen weiteren Anschlusskontakt, über den die Ableitung des pH-abhängigen Potentials zur Auswerteelektronik ermöglicht wird, aufweist.

Hinsichtlich der pH-Halbzelle wird die Aufgabe durch eine pH-Halbzelle entsprechend dem unabhängigen Anspruch 8 gelöst.

Eine vorteilhafte Ausgestaltung sieht vor, dass als Substrat ein Material dient, das einen Ausdehnungskoeffizienten von wenigstens 9 · 10⁻⁶ K⁻¹ hat. Beispielsweise hat sich die Verwendung von Zirkonoxid (ZrO₂) als Substrate als vorteilhaft erwiesen.

Eine weitere vorteilhafte Ausgestaltung sieht vor, dass die erste Struktur Platin oder dotiertes Platin aufweist und die zweite Struktur Platin, dotiertes Platin oder Gold aufweist. In dem Fall, dass die zweite Struktur aus Gold ausgebildet ist, weist die pH-Halbzelle zusätzlich eine Haftschicht, z.B. aus Cr oder TiW, zwischen dem Substrat und der zweiten Struktur aus Gold auf. Insbesondere sieht die Ausgestaltung vor, dass in dem Fall, dass die zweite Struktur Platin oder dotiertes Platin aufweist, eine Goldschicht vorgesehen ist, die die Platin oder dotiertes Platin aufweisende zweite Struktur im Wesentlichen bedeckt, so dass die Goldschicht die zweite Platin oder dotiertes Platin aufweisende Struktur im Wesentlichen bedeckt und das gemischt-leitende Glas die Goldschicht im Wesentlichen bedeckt und das pH-sensitive Glas das gemischt-leitende Glas im Wesentlichen bedeckt.

Eine weitere vorteilhafte Ausgestaltung sieht vor, dass die zweite Struktur derartig ausgebildet ist, dass sie eine im Wesentlichen kreisrunde Grundfläche aufweist und die Passivierungsglasschicht eine im Wesentlichen kreisrunde Öffnung aufweist.

Eine weitere vorteilhafte Ausgestaltung sieht vor, dass die erste Struktur zwei Anschlusskontakte aufweist, über die der Widerstand des Widerstandselementes der ersten Struktur bestimmbar ist und die zweite Struktur einen Anschlusskontakt aufweist, über den das pH-abhängige Potential ableitbar ist.

Eine weitere vorteilhafte Ausgestaltung sieht vor, dass die Passivierungsglasschicht eine Passivierungsglasschichtdicke von nicht weniger als 2 Mikrometer aufweist.

Hinsichtlich des Sensorsystems wird die Aufgabe durch ein Sensorsystem entsprechend dem Anspruch 14 gelöst.

Eine vorteilhafte Ausgestaltung des Sensorsystems sieht vor, dass die zur Bestimmung des pH-Wertes notwendige Referenzelektrode auf einer Oberfläche des Substrates der pH-Halbzelle realisiert ist.

Die Erfindung wird anhand der nachfolgenden Zeichnungen näher erläutert. Es zeigt:
Fig. 1: eine Ausgestaltung der erfindungsgemäßen pH-Halbzelle, die vollständig prozessiert ist,
Fig. 2: eine nicht vollständig prozessierte pH-Halbzelle,
Fig. 3: einen Querschnitt der erfindungsgemäßen pH-Halbzelle,
Fig. 4: ein Sensorsystem zur Bestimmung des pH-Wertes, und
Fig. 5: den erfindungsgemäßen Verfahrensablauf zur Herstellung einer pH-Halbzelle.

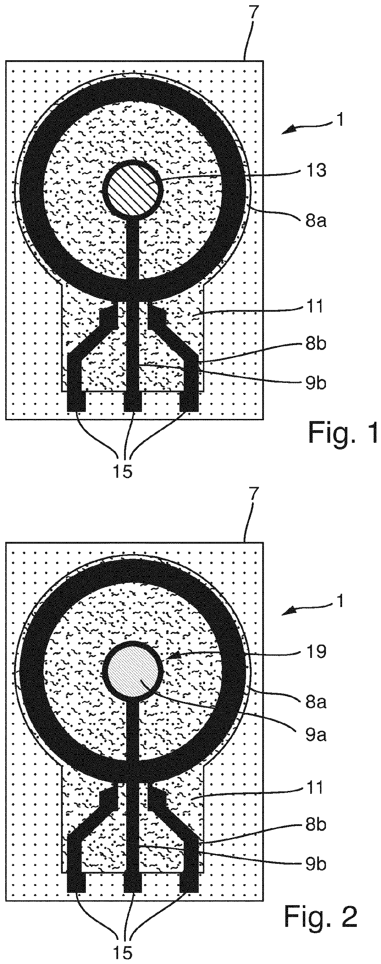

Fig. 1 zeigt eine Ausgestaltung der erfindungsgemäßen pH-Halbzelle. Die pH-Halbzelle weist dabei ein Substrat 7 auf, auf dem eine Platinschicht 6 mittels Dünnschichtprozessen aufgebracht ist.

Das Substrat 7 ist dabei vorzugsweise aus einem Material, das einen Ausdehnungskoeffizienten von zumindest 9 ·10⁻⁶ K⁻¹ aufweist. Als besonders geeignet hat sich hierbei Zirkonoxid (ZrO₂) basierende Materialien, bspw. teil- oder vollstabilisiertes ZrO₂ als Substratmaterialen herausgestellt. Denkbar sind aber auch andere Materialen die einen ähnlichen Ausdehnungskoeffizienten aufweisen. Durch ein Material, das einen entsprechenden Ausdehnungskoeffizienten hat ist dieses an den Ausdehnungskoeffizienten der auf dem Substrat 7 befindlichen Gläser angepasst und wärmeinduzierter Stress bzw. Spannung wird reduziert.

Auf dem Substrat 7 ist eine erste Struktur 8 und eine zweite Struktur 9 aus der Platinschicht 6 ausgebildet. Die erste Struktur 8 bildet dabei ein Widerstandselement 8a mit einem temperaturabhängigen Widerstandswert aus. Als Material für die Herstellung der ersten Struktur 8 wird typischerweise Platin, dotiertes Platin oder auch Gold verwendet. Das Widerstandselement ist vorzugsweise als ein Pt100 oder auch als ein Pt1000 Widerstandselement ausgebildet und sollte somit einen Sollwiderstand von 100 Ohm oder 1000 Ohm besitzen. Um einen derartigen Widerstandswert zu erreichen ist das Widerstandselemente 8a mäanderförmig ausgebildet. Da beim Aufbringen der ersten Struktur 8 sich der Widerstandswert nicht exakt "einstellen" lässt, wird die erste Struktur 8 nach dem Aufbringen typischerweise mittels eines Trimmprozesses auf einen vordefinierten Widerstandswert gemäß der DIN-Norm 60751 aus dem Jahr 2008 gebracht bzw. getrimmt. Typischerweise wird dies mittels Lasertrimmens durchgeführt, wobei die Veränderung des Widerstandwertes durch laserstrahlinduzierte Materialveränderungen entsteht. Um den Widerstandswert des Widerstandselementes der ersten Struktur 8 bestimmen zu können, weist die erste Struktur 8 zwei Leitungen 8b und zwei Anschlusskontakte 15 auf, über die die pH-Halbzelle 1 an eine externe Auswerteelektronik 3 anbindbar ist.

Neben der ersten Struktur 8 wird auf das Substrat 7 auch eine zweite Struktur 9 aufgebracht. Die zweite Struktur 9 dient dabei dazu, ein pH-abhängiges Potential abzuleiten. Hierzu weist die zweite Struktur 9, welche im Wesentlichen mittig auf dem Substrat 7 ausgebildet ist, eine Elektrodenfläche 9a auf, die über eine Leitung 9b mit einem Anschlusskontakt 15 verbunden ist. Der Anschlusskontakt 15 dient wiederum dazu, die zweite Struktur 9 an die externe, d.h. eine separat ausgebildete Auswerteelektronik 3, anzuschließen.

Die Anschlusskontakte 15 sind, wie in Fig. 1 dargestellt, am Rande des Substrates 7 ausgebildet, um von dort einfach mit einer Auswerteelektronik 3 verbunden werden zu können. Eine alternative hierzu sind Durchkontaktierungen durch das Substrat 7, mittels denen ein Anbinden der pH-Halbzelle 1 über die Rückseite des Substrates 7 möglich ist. Dies ist vor allem für die Integration der pH-Halbzelle 1 in ein Assembly von Vorteil.

Wie bereits erwähnt, ist die zweite Struktur 9 im Wesentlichen mittig auf dem Substrat 7 angeordnet. Die Elektrodenfläche 9a der zweiten Struktur 9 ist vorzugsweise kreisrund ausgebildet. Auf dem Substrat 7 mit der ersten Struktur 8 und der zweiten Struktur 9 ist eine strukturierte Passivierungsglasschicht 11 aufgebracht. Diese ist derartig strukturiert, dass sie eine kreisrunde Öffnung 19 im Bereich der Elektrodenfläche 9a aufweist, so dass weitere benötigte Schichten in diese Öffnung 19 eingebracht bzw. aufgebracht werden können. Durch die kreisrunde Ausgestaltung der Elektrodenfläche 9a und somit der kreisrunden Öffnung 19 der Passivierungsglasschicht 11 ist es möglich die internen Spannungen der Passivierungsglasschicht 11, insbesondere im Randbereich der Öffnung 19, reduziert werden. So hat sich bei einer anderen geometrischen Ausgestaltung der Öffnungen 19, insbesondere solche Ausgestaltungen die Kanten oder ähnliches aufweisen, gezeigt, dass es vermehrt zu Rissbildung an den Kanten kommt.

Um die zweite Struktur 9 herum ist die erste Struktur 8, beispielsweise kreisförmig, angeordnet. Denkbar ist aber auch eine andere Geometrie der ersten Struktur 8, beispielsweise eine rechteckige Ausgestaltung des mäanderförmigen Widerstandselementes 8a.

Die erste und die zweite Struktur 8, 9 sind im Idealfall durch einen einzigen Dünnschicht-Prozessschritt auf das Substrat 7 aufgebracht. Es versteht sich von selbst, dass in diesem Fall, das Material aus dem die erste Struktur 8 und die zweite Struktur 9 ausgebildet werden ein und dasselbe ist. Platin hat sich hierbei als besonders günstig herausgestellt, da es chemisch sehr innert ist und somit wenig Einschränkungen bei der Prozesswahl bietet und zusätzlich auch die Möglichkeit bietet, Hochtemperaturprozesse (Prozesse die bei Temperaturen höher 800°C durchgeführt werden müssen) bei der weiteren Prozessierung der pH-Halbzelle anzuwenden. Weiterhin kann Platin auch direkt in Kontakt mit der Messlösung stehen ohne Korresionseffekte zu zeigen. So kann bspw. eine weitere Struktur, die zum Messen einer weiteren physikalischen und/oder chemischen Größe, wie bspw. das Redox-Potential, dient, aus Platin ausgebildet sein. Die erste und zweite Struktur 8, 9, die mittels Dünnschichttechnologie typischerweise zusammen aufgebracht werden, weisen eine maximale Höhe von etwa 2 Mikrometer auf.

Denkbar ist natürlich aber auch, die erste Struktur 8 und die zweite Struktur 9 unterschiedlich voneinander zu erzeugen und somit auch unterschiedliche Materialien zu verwenden und unterschiedliche Höhen der beiden Strukturen zu erzielen.

Wie bereits angedeutet, befindet sich auf der ersten und zweiten Struktur 8, 9 eine strukturierte Passivierungsglasschicht 11, die mittels Dickschichtverfahrens in einem Dickschichtprozessschritt aufgebracht wird. Die Passivierungsglasschicht 11 weist eine minimale Passivierungsglasschichtdicke von 2 Mikrometern auf, wobei aufgrund der Dickschichttechnologie eine maximale Passivierungsglasschichtdicke von etwa 100 Mikrometern möglich ist. Die Passivierungsglasschicht 11 ist derartig ausgebildet, dass eine im Wesentlichen kreisrunde Öffnung 19 aufweist, so dass die ebenfalls im Wesentlichen kreisrunde Grundfläche der Elektrodenfläche 9a der zweiten Struktur 9 für weitere Prozesssierungsschritte zugänglich ist. Fig. 1 zeigt die vollständig prozessierte pH-Halbzelle 1, wohingegen in Fig. 2 eine pH-Halbzelle dargestellt ist, bei der auf dem Substrat 7 lediglich die erste und zweite Struktur 8, 9 sowie die Passivierungsglasschicht 11 aufgebracht ist.

In Fig. 2 ist die Elektrodenfläche 9a mit hellgrau angedeutet, um aufzuzeigen, dass die Grundfläche der Elektrodenfläche 9a der zweiten Struktur 9 trotz der bereits aufgebrachten Passivierungsglasschicht 11 noch frei liegt, und so weitere Schichten auf dieser Fläche aufgebracht werden können. Im Gegensatz dazu, ist die Leitung 9b der zweiten Struktur 9 in schwarz dargestellt, um zu verdeutlichen, dass diese Leitung durch die Passivierungsglasschicht 11 bedeckt ist.

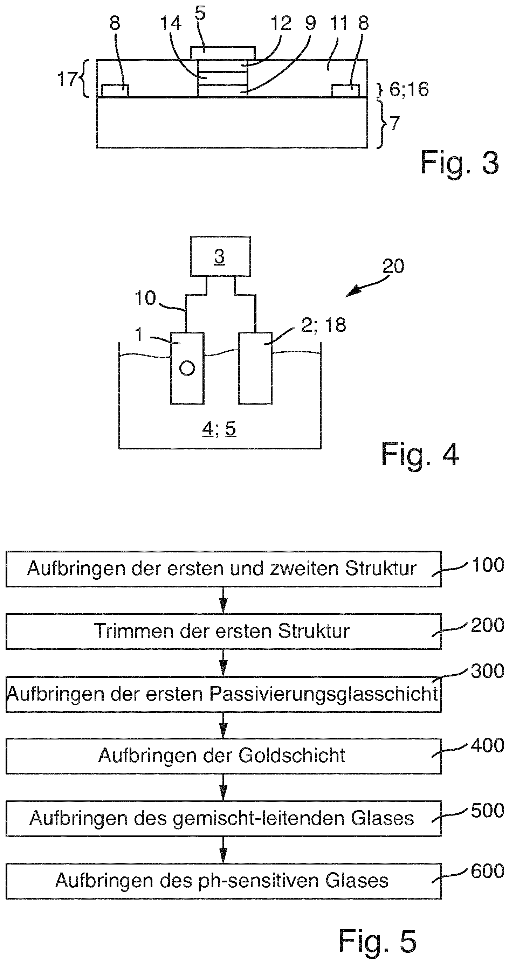

Fig. 3 zeigt einen Querschnitt der erfindungsgemäßen pH-Halbzelle 1, anhand dessen der weitere Aufbau der erfindungsgemäßen pH-Halbzelle 1 beschrieben wird. Die erste und die zweite Struktur 8, 9 sowie die Passivierungsglasschicht 11 sind in Fig. 3 gemäß der Figurenbeschreibung zu Fig. 1 und Fig. 2 ausgebildet. Ausgehend von diesem Aufbau weist die pH-Halbzelle 1 eine Goldschicht 14 auf, die die Elektrodenfläche 9a der zweiten Struktur 9 im Wesentlichen bedeckt. Diese Goldschicht 14 wird typischerweise mittels Dickschichtverfahren aufgebracht. Alternativ kann auch die Goldschicht auch mittels Dünnschichtverfahren aufgebracht werden. Das Aufbringen der Goldschicht 14 ist nur in dem Fall erforderlich, dass die zweite Struktur 9 aus Platin oder dotiertem Platin ausgebildet ist. Denkbar ist auch, die zweite Struktur 9 direkt aus einer Goldschicht 14 auf dem Substrat 7 auszubilden. Dies ist jedoch fertigungstechnisch mit einem erhöhten Aufwand verbunden, so dass es in der Regel günstiger ist, zuerst die zweite Struktur 9 aus Platin oder dotiertem Platin und anschließend die Goldschicht 14 auf die zweite Struktur 9 aufzubringen.

Auf der Goldschicht 14 befindet sich ein gemischt-leitendes Glas 12, das im Wesentlichen in dem von der Passivierungsglasschicht 11 freigelassenem Bereich, also der kreisrunden Öffnung 19, aufgebracht ist. Denkbar ist aber auch, dass das gemischt-leitende Glas 12 nicht nur die Öffnung ausfüllt, sondern auch die Passivierungsglasschicht 11 zusätzlich zumindest teilweise bedeckt.

Das gemischt-leitende Glas 12 ist mittels eines Dickschichtverfahrens aufgebracht und weist eine erste Glasschichtdicke von mindestens 2 Mikrometer auf. Das gemischt-leitenden Glases kann maximal bis zu etwa 100 Mikrometer dick sein.

Auf dem gemischt-leitendem Glas 12 ist abschließend ein pH-sensitives Glas 13 aufgebracht. Dieses pH-sensitive Glas 13 ist wiederum mittels einer der bekannten Dickschichtverfahren aufgebracht.

Wie in Fig. 3 unschwer zu erkennen ist, sind die zweite Struktur 9, insbesondere die Elektrodenfläche 9a der zweiten Struktur 9, das gemischt-leitende Glas 12, als auch die Goldschicht 14 durch die Passivierungsglasschicht 11 und das pH-sensitive Glas 13 derartig umgeben, dass ein Kontakt mit dem Medium 5 ausgeschlossen ist bzw. verhindert wird.

Fig. 4 zeigt ein Sensorsystem 20 zur Bestimmung des pH-Wertes 4 des Mediums 5, wobei das Sensorsystem 20 ein pH-Halbzelle 1, die gemäß der Figurenbeschreibungen der Figuren 1 bis 3 ausgebildet ist, eine Referenzelektrode 2 und eine Auswerteelektronik umfasst. Die pH-Halbzelle 1 ist dabei über die drei Anschlusskontakte 15 mit der Auswerteelektronik 3 verbunden, die somit zum einen das pH-abhängige Potential ableitet, um daraus den pH-Wert 4 des Mediums 5 zu bestimmen und zum anderen den Widerstandswert des Widerstandselementes 8a der ersten Struktur 8 misst, um daraus die Temperatur des Mediums 5 zu ermitteln. Ein derartiges Sensorsystem 20 ist somit in der Lage zeitgleich bzw. parallel den pH-Wert 4 und die Temperatur des Mediums 5 zu bestimmen. Wie bereits eingangs erwähnt, ist es bei geeigneter Ausgestaltung der pH-Halbzelle 1 möglich, neben der Temperatur als Messgröße auch andere oder gegebenenfalls zusätzliche weitere Größen, wie bspw. das Redox-Potential, zu messen.

Zum Bestimmen des pH-Wertes 4 benötigt die Auswertelektronik 3 eine Referenzelektrode 2 bzw. eine Referenzhalbzelle. Diese Referenzelektrode 2 kann beispielsweise eine separat von der pH-Halbzelle 1 ausgebildete und aus dem Stand der Technik bekannte Referenzelektrode 2 sein. Aufgrund der Kombination der beiden Fertigungsverfahren, also der Dick- und der Dünschichttechnologie besteht aber auch die Möglichkeit eine interne Referenzelektrode auf der pH-Halbzelle 1 auszubilden und für die Auswertung des pH-Wertes 4 zu verwenden. Je nach Appliaktion ist jedoch dies auch nicht immer nötig, so dass bspw. von einem ionensensitiven Sensor ein Referenzsignal vorhanden ist oder aber, dass aufgrund des Wissen um die Abläufe auf eine Silber-Silberchlorid- (Ag/AgCI-) Pseudoreferenz (d.h. eine Referenzelektrode ohne Diaphragma und KCl Pufferlösung) oder eine reine Platin-Referenz zurückgegriffen werden kann.

Fig. 5 zeigt exemplarisch den erfindungsgemäßen Verfahrensablauf zur Herstellung einer pH-Halbzelle 1. Hierbei wird in einem ersten Schritt 100, die erste Struktur 8 und die zweite Struktur 9 mittels eines Dünnschichtverfahrens, bspw. Sputtern, Aufdampfen oder chemischer Gasphasenabscheidung aufgebracht. In einem zweiten Schritt 200 wird das mäanderförmige Widerstandselement 8a der ersten Struktur 8 auf einen vorgegebenen Widerstandswert bei Referenzbedingungen getrimmt. In einem dritten Schritt 300 wird die strukturierte Passivierungsglasschicht 11 mittels eines Dickschichtverfahrens, bspw. Siebdruck, Schablonendruck, Tauch- oder Inkjetverfahren, aufgebracht. In einem vierten Schritt 400 wird die Goldschicht 14 mittels eines Dickschichtverfahrens aufgebracht. Wie bereits erwähnt, kann auch die zweite Struktur 9 bereits aus Gold ausgebildet sein, so dass das zusätzliche aufbringen der Goldschicht 14 in diesem Fall nicht nötig ist. In einem fünften Schritt 500 wird das gemischt-leitende Glas 12 mittels eines Dickschichtverfahrens aufgebracht. Abschließend wird in einem sechsten Schritt 600 das pH-sensitive Glas 13 aufgebracht.

### Bezugszeichenliste

- 1: pH-Halbzelle
- 2: Referenzelektrode
- 3: Auswerteelektronik
- 4: pH-Wert
- 5: Medium
- 6: Platinschicht
- 7: Substrat
- 8a: Widerstandselement der erste Struktur
- 8b: Leitung der ersten Struktur
- 9a: Elektrodenfläche der zweite Struktur
- 9b: Leitung der zweiten Struktur
- 10: pH-abhängiges Potential
- 11: Passivierungsglasschicht
- 12: Gemischt-leitendes Glas
- 13: pH-sensitives Glas
- 14: Goldschicht
- 15: Anschlusskontakte
- 16: Schichtdicke der ersten und zweiten Struktur
- 17: Passivierungsglasschichtdicke
- 18: Separate Halbzelle
- 19: Kreisrunde Öffnung
- 20: Sensorsystem

## Patentansprüche

1. Verfahren zur Herstellung einer pH-Halbzelle (1), mittels derer, in Kombination mit einer Referenzelektrode (2) und einer Auswerteelektronik (3), ein pH-Wert (4) eines Mediums (5) bestimmbar ist, wobei das Verfahren zur Herstellung der pH-Halbzelle (1) die folgenden Schritte aufweist:
- Aufbringen einer ersten Struktur (8) und einer zweiten Struktur (9) auf ein Substrat (7), wobei die erste Struktur (8) mittels eines Dünnschichtverfahrens aufgebracht wird und ein Widerstandselement mit temperaturabhängigem Widerstandswert ausbildet, wobei die zweite Struktur (9) zur Ableitung eines pH-abhängigen Potentials (10) verwendbar ist und wobei die erste Struktur (8) nach dem Aufbringen auf einen vorgegebenen Widerstandswert bei Referenzbedingungen getrimmt wird, wobei die Referenzbedingungen in der DIN-Norm 60751 aus dem Jahr 2008 beschrieben, bzw. vorgegeben sind;
- Aufbringen einer strukturierten Passivierungsglasschicht (11), wobei die Passivierungsglasschicht (11) die erste Struktur (8) im Wesentlichen bedeckt und die zweite Struktur (9) im Wesentlichen frei lässt;
- Aufbringen eines gemischt-leitenden Glases (12), wobei das gemischt leitende Glas (12) im Wesentlichen in dem Bereich, der von der Passivierungsglasschicht (11) frei gelassen wurde, aufgebracht wird;
- Aufbringen eines pH-sensitiven Glases (13), wobei das pH-sensitive Glas (13) auf das gemischt-leitende Glas (12) aufgebracht wird.

2. Verfahren nach Anspruch 1, wobei die zweite Struktur (9) mittels eines Dünnschichtverfahrens aufgebracht wird, wobei als Dünnschichtverfahren insbesondere ein Sputter-, ein Aufdampf- oder ein chemisches Gasphasenabscheidungsverfahren verwendet wird.

3. Verfahren nach Anspruch 1 oder 2, wobei die strukturierte Passivierungsglasschicht (11), das gemischt-leitende Glas (12) und das pH-sensitive Glas (13) mittels eines Dickschichtverfahrens aufgebracht werden, wobei als Dickschichtverfahren insbesondere ein Siebdruck-, ein Schablonendruck-, ein Tauch- oder ein Inkjetverfahren verwendet wird.

4. Verfahren nach einem oder mehreren der vorhergehenden Ansprüche, wobei das Material aus dem die erste Struktur (8) gebildet wird, Platin oder dotiertes Platin aufweist.

5. Verfahren nach einem oder mehreren der vorhergehenden Ansprüche, wobei das Material aus dem die zweite Struktur (9) gebildet wird, Platin, dotiertes Platin oder Gold aufweist.

6. Verfahren nach Anspruch 5, wobei in dem Fall, dass die zweite Struktur aus Platin oder dotiertem Platin ausgebildet wird, eine Goldschicht (14) auf die aus Platin oder dotiertem Platin ausgebildete zweite Struktur (9) aufgebracht wird, so dass die Goldschicht (14) die zweite aus Platin oder dotiertem Platin ausgebildete Struktur (9) im Wesentlichen bedeckt und das gemischt-leitende Glas (12) die Goldschicht (14) im Wesentlichen bedeckt und das pH-sensitive Glas (13) das gemischt-leitende Glas (12) im Wesentlichen bedeckt.

7. Verfahren nach einem oder mehreren der vorhergehenden Ansprüche, wobei die erste Struktur (8) so ausgebildet wird, dass sie zumindest zwei Anschlusskontakte (15), über die das Widerstandselement an die Auswertelektronik elektrisch angeschlossen wird, aufweist und die zweite Struktur (9) so ausgebildet wird, dass sie zumindest einen weiteren Anschlusskontakt (15), über den die Ableitung des pH-abhängigen Potentials zur Auswerteelektronik (3) ermöglicht wird, aufweist.

8. pH-Halbzelle (1) die insbesondere nach einem oder mehreren der vorhergehenden Ansprüche herstellbar ist zumindest aufweisend:
- ein Substrat (7),
- eine auf dem Substrat ausgebildete erste Struktur (8) und eine zweite Struktur (9), wobei die erste Struktur (8) ein Widerstandselement mit temperaturabhängigem Widerstandswert ausbildet und die zweite Struktur (9) zur Ableitung eines pH-abhängigen Potentials (10) verwendbar ist, wobei die erste und die zweite Struktur (8, 9) eine Schichtdicke (16) von maximal 2 Mikrometer aufweisen, und wobei die erste Struktur (8) nach dem Aufbringen auf einen vorgegebenen Widerstandswert bei Referenzbedingungen getrimmt ist, wobei die Referenzbedingungen in der DIN-Norm 60751 aus dem Jahr 2008 beschrieben, bzw. vorgegeben sind
- eine strukturierte Passivierungsglasschicht (11), die die erste Struktur (8) im Wesentlichen bedeckt und die zweite Struktur (9) im Wesentlichen frei lässt,
- ein gemischt-leitendes Glas (12), das im Wesentlichen in dem von der Passivierungsglasschicht (11) freigelassenen Bereich, aufgebracht ist, wobei das gemischt-leitende Glas (12) eine erste Glasschichtdicke von nicht weniger als 2 Mikrometer aufweist,
- ein pH-sensitives Glas (13), das auf das gemischt-leitende Glas (12) aufgebracht ist, wobei das pH-sensitive Glas (13) eine zweite Glasschichtdicke von nicht weniger als 2 Mikrometer aufweist.

9. pH-Halbzelle nach Anspruch 8, wobei als Substrat (7) ein Material dient, das einen Ausdehnungskoeffizienten von wenigstens 9 ·10⁻⁶ K⁻¹ hat.

10. pH-Halbzelle nach Anspruch 8 oder 9, wobei die erste Struktur (8) Platin oder dotiertes Platin aufweist und die zweite Struktur (9) Platin, dotiertes Platin oder Gold aufweist.

11. pH-Halbzelle nach Anspruch 10, wobei in dem Fall, dass die zweite Struktur (9) Platin oder dotiertes Platin aufweist, eine Goldschicht (14) vorgesehen ist, die die Platin oder dotiertes Platin aufweisende zweite Struktur (9) im Wesentlichen bedeckt, so dass die Goldschicht (14) die zweite Platin oder dotiertes Platin aufweisende Struktur (9) im Wesentlichen bedeckt und das gemischt-leitende Glas (12) die Goldschicht (14) im Wesentlichen bedeckt und das pH-sensitive Glas (13) das gemischt-leitende Glas (12) im Wesentlichen bedeckt.

12. pH-Halbzelle nach einem der Ansprüche 8 bis 11, wobei die zweite Struktur (9) derartig ausgebildet ist, dass sie eine im Wesentlichen kreisrunde Grundfläche aufweist und die Passivierungsglasschicht (11) eine im Wesentlichen kreisrunde Öffnung (19) aufweist und/oder wobei die erste Struktur (8) zwei Anschlusskontakte (15) aufweist, über die der Widerstand des Widerstandselementes der ersten Struktur bestimmbar ist und die zweite Struktur (9) einen Anschlusskontakt (15) aufweist, über den das pH-abhängige Potential (10) ableitbar ist [Patentanspruch 14].

13. pH-Halbzelle nach einem der Ansprüche 8 bis 12, wobei die Passivierungsglasschicht (11) eine Passivierungsglasschichtdicke (17) von nicht weniger als 2 Mikrometer aufweist.

14. Sensorsystem zur Bestimmung eines pH-Wertes (4) eines Mediums (5) mit einer pH-Halbzelle (1) nach einem der Ansprüche 8 bis 13, einer Referenzelektrode (2) und einer Auswerteelektronik (3).

15. Sensorsystem nach Anspruch 14, wobei die zur Bestimmung des pH-Wertes (4) notwendige Referenzelektrode (2) auf einer Oberfläche des Substrates der pH-Halbzelle (1) realisiert ist.

## Claims

1. Procedure to manufacture a pH half-cell (1) by means of which a pH value (4) of a medium (5) can be determined in combination with a reference electrode (2) and an evaluation electronics unit (3), wherein said procedure to manufacture the pH half-cell (1) comprises the following steps:
- Application of a first structure (8) and a second structure (9) on a substrate (7), wherein the first structure (8) is applied using a thin-film procedure and forms a resistance element with a temperature-dependent resistance value, wherein the second structure (9) can be used to derive a pH-dependent potential (10), and wherein the first structure (8) is trimmed, following the application, to a predefined resistance value at reference conditions, the reference conditions being described or specified in the standard DIN 60751 from 2008;
- Application of a structured passivation glass layer (11), wherein the passivation glass layer (11) essentially covers the first structure (8) and leaves the second structure (9) essentially free;
- Application of a mixed-conductive glass (12), wherein the mixed-conductive glass (12) is applied essentially in the zone left free by the passivation glass layer (11);
- Application of a pH-sensitive glass (13), wherein the pH-sensitive glass (13) is applied to the mixed-conductive glass (12).

2. Procedure as claimed in Claim 1, wherein the second structure (9) is applied using a thin-film procedure, wherein a sputter procedure, an evaporation procedure or a chemical vapor deposition procedure is used as the thin-film procedure.

3. Procedure as claimed in Claim 1 or 2, wherein the structured passivation glass layer (11), the mixed-conductive glass (12) and the pH-sensitive glass (13) are applied using a thick-film procedure, wherein a screen printing procedure, a stencil print procedure, a dipping procedure or an ink-jet procedure is used as the thick-film procedure.

4. Procedure as claimed in one or more of the previous claims, wherein the material from which the first structure (8) is made comprises platinum or doped platinum.

5. Procedure as claimed in one or more of the previous claims, wherein the material, from which the second structure (9) is made comprises platinum, doped platinum or gold.

6. Procedure as claimed in Claim 5, wherein in the event that the second structure is made from platinum or doped platinum, a gold layer (14) is applied to the second structure (9) formed from platinum or doped platinum in such a way that the gold layer (14) essentially covers the second structure (9) made from platinum or doped platinum and the mixed-conductive glass (12) essentially covers the gold layer (14) and the pH-sensitive glass (13) essentially covers the mixed-conductive glass (12).

7. Procedure as claimed in one or more of the previous claims, wherein the first structure (8) is designed in such a way that it features at least two connection contacts (15) by means of which the resistance element is connected electrically to the evaluation electronics unit, and the second structure (9) is designed in such a way that it features at least an additional connection contact (15), by means of which it is possible to derive the pH-dependent potential towards the evaluation electronics unit (3).

8. pH half-cell (1) which can be manufactured particularly according to one or more of the previous claims, said half-cell comprising at least:
- a substrate (7),
- a first structure (8) formed on the substrate and a second structure (9), wherein the first structure (8) forms a resistance element with a temperature-dependent resistance value and the second structure (9) can be used to derive a pH-dependent potential (10), wherein the first and the second structure (8, 9) have a maximum layer thickness (16) of 2 micrometers, and wherein the first structure (8) is trimmed, following the application, to a predefined resistance value at reference conditions, wherein the reference conditions are described or specified by the standard DIN 60751 of 2008
- a structured passivation glass layer (11), which essentially covers the first structure (8) and essentially leaves the second structure (9) free
- a mixed-conductive glass (12) which is essentially applied in the zone left free by the passivation glass layer (11), wherein the mixed-conductive glass (12) has a first glass layer thickness of no less than 2 micrometers,
- a pH-sensitive glass (13), which is applied to the mixed-conductive glass (12), wherein the pH-sensitive glass (13) has a second glass layer thickness of no less than 2 micrometers.

9. pH half-cell as claimed in Claim 8, wherein a material with a thermal expansion coefficient of at least 9 · 10⁻⁶ K⁻¹ is used as the substrate (7).

10. pH half-cell as claimed in Claim 8 or 9, wherein the first structure (8) comprises platinum or doped platinum and the second structure (9) comprises platinum, doped platinum or gold.

11. pH half-cell as claimed in Claim 10, wherein, in the event that the second structure (9) comprises platinum or doped platinum, a gold layer (14) is provided to essentially cover the second structure (9) featuring platinum or doped platinum in such a way that the gold layer (14) essentially covers the second structure (9) featuring platinum or doped platinum and the mixed-conductive glass (12) essentially covers the gold layer (14) and the pH-sensitive glass (13) essentially covers the mixed-conductive glass (12).

12. pH half-cell as claimed in one of the Claims 8 to 11, wherein the second structure (9) is made in such a way that it has an essentially circular base area and the passivation glass layer (11) has an essentially circular opening (19) and/or wherein the first structure (8) has two connection contacts (15) by means of which the resistance of the resistance element of the first structure can be determined, and the second structure (9) has a connection contact (15) by means of which the pH-dependent potential (10) can be derived [Claim 14].

13. pH half-cell as claimed in one of the Claims 8 to 12, wherein the passivation glass layer (11) has a passivation glass layer thickness (17) of no less than 2 micrometers.

14. Sensor system for determining a pH value (4) of a medium (5) with a pH half-cell as claimed in one of the Claims 8 to 13, a reference electrode (2) and an evaluation electronics unit (3).

15. Sensor system as claimed in Claim 14, wherein the reference electrode (2) required to determine the pH value (4) is implemented on a surface of the substrate of the pH half-cell (1).

## Revendications

1. Procédé de fabrication d'une demi-cellule de pH (1), demi-cellule au moyen de laquelle, en combinaison avec une électrode de référence (2) et une électronique d'exploitation (3), une valeur de pH (4) d'un produit (5) peut être déterminée, le procédé de fabrication de la demi-cellule de pH (1) comprenant les étapes suivantes :
- Application d'une première structure (8) et d'une deuxième structure (9) sur un substrat (7), la première structure (8) étant appliquée au moyen d'un procédé en couche mince et formant un élément résistif avec une valeur de résistance dépendant de la température, la deuxième structure (9) pouvant être utilisée pour dériver un potentiel (10) dépendant du pH, et la première structure (8) étant ajustée, après l'application, à une valeur de résistance prédéfinie dans des conditions de référence, les conditions de référence étant décrites ou spécifiées dans la norme DIN 60751 de 2008 ;
- Application d'une couche de verre de passivation (11) structurée, la couche de verre de passivation (11) recouvrant pour l'essentiel la première structure (8) et laissant la deuxième structure (9) pour l'essentiel libre ;
- Application d'un verre conducteur mixte (12), le verre conducteur mixte (12) étant appliqué pour l'essentiel dans la zone laissée libre par la couche de verre de passivation (11) ;
- Application d'un verre sensible au pH (13), le verre sensible au pH (13) étant appliqué sur le verre conducteur mixte (12).

2. Procédé selon la revendication 1, pour lequel la deuxième structure (9) est appliquée au moyen d'un procédé en couche mince, le procédé en couche mince utilisé étant notamment un procédé de pulvérisation, un procédé de métallisation sous vide ou un procédé de dépôt chimique en phase vapeur.

3. Procédé selon la revendication 1 ou 2, pour lequel la couche de verre de passivation (11) structurée, le verre conducteur mixte (12) et le verre sensible au pH (13) sont appliqués au moyen d'un procédé en couche épaisse, le procédé en couche épaisse utilisé étant notamment un procédé de sérigraphie, un procédé d'impression au pochoir, un procédé de trempage ou un procédé à jet d'encre.

4. Procédé selon l'une ou plusieurs des revendications précédentes, pour lequel le matériau, à partir duquel la première structure (8) est formée, comprend du platine ou du platine dopé.

5. Procédé selon l'une ou plusieurs des revendications précédentes, pour lequel le matériau, à partir duquel la deuxième structure (9) est formée, comprend du platine, du platine dopé ou de l'or.

6. Procédé selon la revendication 5, pour lequel, dans le cas où la deuxième structure est formée de platine ou de platine dopé, une couche d'or (14) est appliquée à la deuxième structure (9) formée de platine ou de platine dopé, de telle sorte que la couche d'or (14) recouvre pour l'essentiel la deuxième structure (9) formée de platine ou de platine dopé et le verre conducteur mixte (12) recouvre pour l'essentiel la couche d'or (14) et le verre sensible au pH (13) recouvre pour l'essentiel le verre conducteur mixte (12).

7. Procédé selon l'une ou plusieurs des revendications précédentes, pour lequel la première structure (8) est réalisée de telle sorte qu'elle présente au moins deux contacts de raccordement (15), par l'intermédiaire desquels l'élément résistif est relié électriquement à l'électronique d'exploitation, et la deuxième structure (9) est réalisée de telle sorte qu'elle présente au moins un autre contact de raccordement (15), par l'intermédiaire duquel la dérivation du potentiel dépendant du pH vers l'électronique d'exploitation (3) est rendue possible.

8. Demi-cellule de pH (1) pouvant être réalisée notamment selon une ou plusieurs des revendications précédentes, laquelle demi-cellule comprend au moins :
- un substrat (7),
- une première structure (8) formée sur le substrat et une deuxième structure (9), la première structure (8) formant un élément résistif avec une valeur de résistance dépendant de la température et la deuxième structure (9) pouvant être utilisée pour dériver un potentiel (10) dépendant du pH, la première et la deuxième structure (8, 9) présentant une épaisseur de couche (16) d'au maximum 2 micromètres, et la première structure (8) étant ajustée, après application, à une valeur de résistance prédéfinie dans des conditions de référence, les conditions de référence étant décrites ou spécifiées dans la norme DIN 60751 de 2008
- une couche de verre de passivation (11) structurée, qui recouvre pour l'essentiel la première structure (8) et laisse la deuxième structure (9) pour l'essentiel libre
- un verre conducteur mixte (12), lequel verre est appliqué pour l'essentiel dans la zone laissée libre par la couche de verre de passivation (11), le verre conducteur mixte (12) présentant une première épaisseur de couche de verre non inférieure à 2 micromètres,
- un verre sensible au pH (13), lequel est appliqué sur le verre conducteur mixte (12), le verre sensible au pH (13) présentant une deuxième épaisseur de couche de verre non inférieure à 2 micromètres.

9. Demi-cellule de pH selon la revendication 8, pour laquelle on utilise, en tant que substrat (7), un matériau présentant un coefficient de dilatation d'au moins 9·10⁻⁶ K⁻¹.

10. Demi-cellule de pH selon la revendication 8 ou 9, pour laquelle la première structure (8) comprend du platine ou du platine dopé et la deuxième structure (9) comprend du platine, du platine dopé ou de l'or.

11. Demi-cellule de pH selon la revendication 10, pour laquelle, dans le cas où la deuxième structure (9) comprend du platine ou du platine dopé, une couche d'or (14) est prévue pour couvrir pour l'essentiel la deuxième structure (9) en platine ou en platine dopé, de telle sorte que la couche d'or (14) recouvre pour l'essentiel la deuxième structure (9) en platine ou en platine dopé et le verre conducteur mixte (12) recouvre pour l'essentiel la couche d'or (14) et le verre sensible au pH (13) recouvre pour l'essentiel le verre conducteur mixte (12).

12. Demi-cellule de pH selon l'une des revendications 8 à 11, pour laquelle la deuxième structure (9) est formée de telle sorte qu'elle présente une surface de base pour l'essentiel circulaire et la couche de verre de passivation (11) présente une ouverture (19) pour l'essentiel circulaire et/ou la première structure (8) présentant deux contacts de raccordement (15) par l'intermédiaire desquels la résistance de l'élément résistif de la première structure peut être déterminée, et la deuxième structure (9) présentant un contact de raccordement (15) par l'intermédiaire duquel le potentiel (10) dépendant du pH peut être dérivé [revendication 14].

13. Demi-cellule de pH selon l'une des revendications 8 à 12, pour laquelle la couche de verre de passivation (11) présente une épaisseur de couche de verre de passivation (17) non inférieure à 2 micromètres.

14. Système de capteur destiné à la détermination d'une valeur de pH (4) d'un produit (5) avec une demi-cellule de pH selon l'une des revendications 8 à 13, une électrode de référence (2) et une électronique d'exploitation (3).

15. Système de capteur selon la revendication 14, pour lequel l'électrode de référence (2) nécessaire pour déterminer la valeur de pH (4) est réalisée sur une surface du substrat de la demi-cellule de pH (1).
